(19) Europäisches Patentamt / European Patent Office / Office européen des brevets

(11) **EP 1 473 833 B1**

(12) **FASCICULE DE BREVET EUROPEEN**

(45) Date de publication et mention
de la délivrance du brevet:
**09.05.2012 Bulletin 2012/19**

(51) Int Cl.:
**H03H 7/38** *(2006.01)* **H03H 7/09** *(2006.01)*
**H04B 1/00** *(2006.01)*

(21) Numéro de dépôt: **04300183.3**

(22) Date de dépôt: **02.04.2004**

(54) **Inductance bi-bande intégrée et applications**

Integrierte zwei-band Induktivität und Anwendungen

Integrated two-band inductance and its applications

(84) Etats contractants désignés:
**DE FR GB IT**

(30) Priorité: **03.04.2003 FR 0304148**

(43) Date de publication de la demande:
**03.11.2004 Bulletin 2004/45**

(73) Titulaire: **STMicroelectronics S.A.**
**92120 Montrouge (FR)**

(72) Inventeurs:
• **Guitton, Fabrice**
**37100 Tours (FR)**
• **Dupont, François**
**37000 Tours (FR)**

(74) Mandataire: **de Beaumont, Michel**
**1bis, rue Champollion**
**38000 Grenoble (FR)**

(56) Documents cités:
**EP-A- 0 758 821      WO-A-01/37323**
**DE-A- 10 052 719     US-A- 5 095 285**

• **WU Y-C ET AL: "On-chip high-Q(>3000) transformer-type spiral inductors" ELECTRONICS LETTERS, IEE STEVENAGE, GB, vol. 38, no. 3, 31 janvier 2002 (2002-01-31), pages 112-113, XP006017805 ISSN: 0013-5194**

**Description**

La présente invention concerne le domaine des inductances et plus particulièrement la réalisation d'une inductance dont la valeur est modifiée en fonction de la fréquence du signal qui lui est appliqué.

Un exemple d'application de la présente invention concerne les chaînes d'émission-réception radiofréquences, par exemple, du type de celles utilisées dans des téléphones portables bi-bande, c'est-à-dire aptes à fonctionner sur deux bandes de fréquence (par exemple, GSM et DCS).

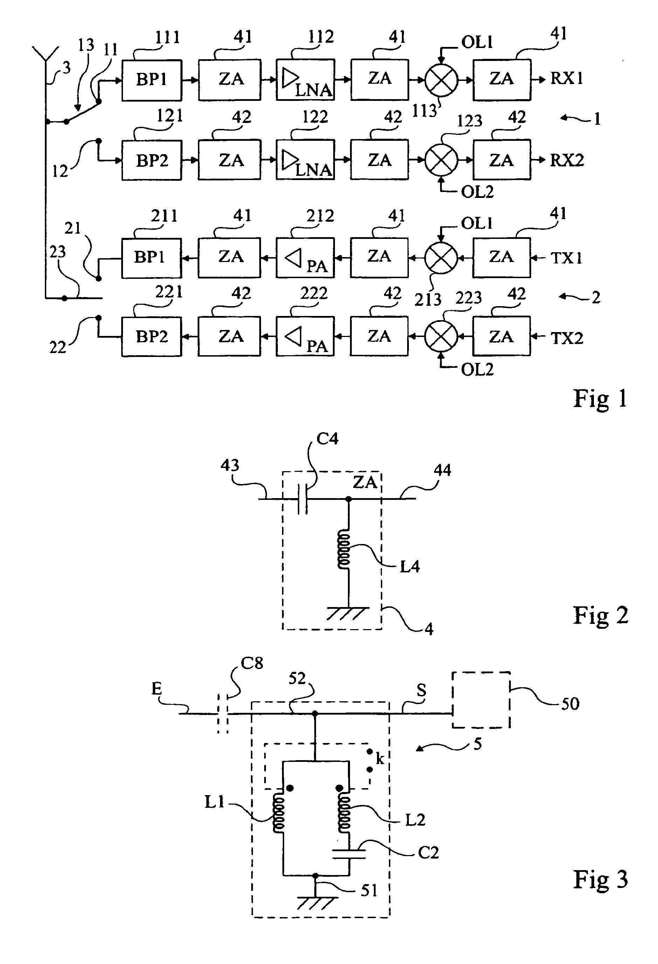

La figure 1 représente, de façon très schématique et sous forme de blocs, un exemple classique de système d'émission-réception radiofréquences bi-bande du type auquel s'applique la présente invention. L'architecture d'un tel système peut se décrire sous la forme d'une chaîne 1 de réception et d'une chaîne 2 d'émission, toutes deux reliées à une antenne 3.

Côté réception 1, on dispose de deux voies de réception parallèles fournissant chacune un signal RX1 ou RX2 selon la bande de fréquence à laquelle est reçu le signal, à destination d'un système d'interprétation non représenté, généralement un système numérique. Chaque voie comporte, entre une borne 11 ou 12 de connexion à l'antenne 3 par l'intermédiaire d'un interrupteur 13 de sélection de bande :

un filtre passe bande 111 (BP 1) ou 121 (BP 2) centré sur la fréquence de la bande correspondante ;
un amplificateur 112, 122 à faible bruit (LNA) ; et
un mélangeur 113, 123 du signal issu de l'amplificateur précédent avec un signal fourni par un oscillateur local OL1, OL2 à la fréquence de la bande de la voie concernée. Les sorties respectives des mélangeurs 113 et 123 fournissent les signaux reçus RX1 et RX2.

Pour un fonctionnement correct de la chaîne de réception 1, il est nécessaire de prévoir, entre chaque constituant de la chaîne, un élément d'adaptation d'impédance (ZA) généralement à 50 ohms. Ainsi, des éléments 41 sont respectivement prévus entre le filtre 111 et l'amplificateur 112, entre l'amplificateur 112 et le mélangeur 113, et en sortie du mélangeur 113 avant le système d'interprétation des signaux reçus RX1. De même, côté deuxième voie, des éléments d'adaptation d'impédance 42 sont respectivement prévus entre le filtre 121 et l'amplificateur 122, entre l'amplificateur 122 et le mélangeur 123 et en sortie du mélangeur 123. Les éléments 41 et 42 diffèrent par la fréquence centrale de la bande concernée.

Côté chaîne d'émission, on retrouve sensiblement la même architecture, à savoir que chaque voie comporte, entre le système de fourniture d'un signal TX1 ou TX2 à transmettre et une borne 21 ou 22 destinée à être connectée, par un interrupteur 23, à l'antenne 3 :

un mélangeur 213, 223 des signaux à émettre avec un signal fourni par un oscillateur local OL1, OL2 à la fréquence centrale de la bande passante de la voie considérée ;
un amplificateur de puissance (PA) 212, 222 ; et
un filtre passe bande 211 (BP1), 221 (BP2), centré sur la fréquence centrale de la bande passante de la voie considérée.

Comme pour la chaîne de réception, il est nécessaire de prévoir des éléments d'adaptation d'impédance 41 entre l'amplificateur 212 et le filtre 211, entre le mélangeur 213 et l'amplificateur 212 et en entrée du mélangeur 213, et des éléments 42 entre l'amplificateur 222 et le filtre 221, le mélangeur 223 et l'amplificateur 222 et en entrée du mélangeur 223.

La figure 2 représente un exemple classique d'élément 4 d'adaptation d'impédance. Un tel élément est généralement constitué entre deux bornes 43 et 44 d'entrée et de sortie de l'élément 4, d'un condensateur C4 et d'une inductance L4. L'inductance L4 relie une électrode du condensateur (connectée à la borne 44), à la masse. Le condensateur et l'inductance de l'élément 4 sont dimensionnés de telle sorte qu'à la fréquence de travail (fréquence centrale de la bande passante souhaitée pour le système), le circuit d'adaptation d'impédance présente d'un côté l'impédance complexe conjuguée du circuit à adapter (par exemple, un transistor), lorsqu'il est chargé de l'autre côté par l'impédance désirée (par exemple, 50 ohms). Généralement, l'impédance du circuit à adapter varie en fonction de la fréquence. De plus, pour une même impédance à adapter, la valeur des éléments varie en fonction de la fréquence de travail.

On voit bien que, pour constituer une chaîne d'émission ou de réception bi-bande, les éléments d'adaptation d'impédance doivent être dimensionnés de façon différente selon la voie concernée.

Ce besoin d'éléments d'adaptation d'impédance distincts nuit à la miniaturisation des circuits électroniques (par exemple, des chaînes d'émission-réception radiofréquences dans l'exemple considéré).

Dans cette application, le fait que les éléments d'adaptation d'impédance sont dédiés à chaque bande de fréquence impose d'utiliser des amplificateurs et mélangeurs distincts pour chaque bande de fréquence. Ce problème est particulièrement présent dans le cas où les amplificateurs d'émission ou de réception sont intégrés, sans élément d'adaptation d'impédance.

Plus généralement, dans toute application bi-bande ou multi-bande pour laquelle un élément inductif est dimensionné en fonction de la fréquence de la bande concernée et ne peut pas s'adapter à la fréquence d'une autre bande, on assiste à un problème d'encombrement du circuit électronique en raison de la taille nécessaire des éléments inductifs. Ce problème est particulièrement présent pour la réalisation d'éléments inductifs en circuit intégré constitués d'enroulements plans sur une surface de circuit intégré ou d'un substrat quelconque.

L'article "Original topology of GAAS-PHEMT mixer" de D.Dubuc et al. décrit un circuit dans lequel deux branches parallèles comportent respectivement une inductance seule et une inductance et un condensateur en série. Les inductances de ce circuit ne sont pas couplées l'une à l'autre.

La présente invention vise à palier les inconvénients des solutions connues ayant recours à des circuits inductifs séparés pour fonctionner sur deux bandes de fréquences.

Plus précisément, l'invention vise à proposer la réalisation d'un circuit inductif susceptible de fonctionner sur au moins deux bandes de fréquence.

L'invention vise également à simplifier la réalisation d'un tel élément inductif sous forme de circuit intégré.

L'invention vise également à proposer une solution particulièrement adaptée à la réalisation d'élément résonateur bi-bande.

L'invention vise également. à proposer une solution particulièrement adaptée à la réalisation d'élément d'adaptation d'impédance bi-bande..

L'invention vise également à proposer une nouvelle architecture de chaîne d'émission ou de réception radiofréquences bi-bande..

Pour atteindre ces objets et d'autres, la présente invention prévoit un circuit inductif multi-bande en circuit intégré, définissant un dipôle et comprenant au moins deux branches parallèles comprenant, respectivement, une première inductance et une deuxième inductance en série avec un condensateur, les deux inductances étant couplées l'une à l'autre.

Selon un mode.de réalisation de la présente invention, n branches parallèles comprennent chacune une inductance, n-1 de ces branches comprenant en outre un condensateur en série, afin de constituer un élément inductif à n bandes.

Selon un mode de réalisation de la présente invention, les inductances sont réalisées par des enroulements conducteurs plan superposés.

Selon un mode de réalisation de la présente invention, la valeur de la première inductance est choisie pour correspondre approximativement à une première fréquence de coupure ou à la fréquence centrale d'une première bande d'adaptation d'impédance, souhaitée pour l'élément inductif.

Selon un mode de réalisation de la présente invention, la deuxième inductance est choisie pour correspondre approximativement à une valeur telle que l'inductance équivalente des deux éléments en parallèle correspond à la valeur souhaitée pour une deuxième fréquence de coupure ou pour la fréquence centrale d'une deuxième bande d'adaptation d'impédance de l'élément inductif.

Selon un mode de réalisation de la présente invention, la valeur du condensateur est choisie en fonction d'une fréquence de résonance souhaitée pour l'élément inductif.

Selon un mode de réalisation de la présente invention, le condensateur est variable de sorte à réaliser un filtre programmable.

L'invention prévoit également un circuit d'adaptation d'impédance comportant un élément inductif multi-bande et au moins un condensateur et/ou inductance.

L'invention prévoit également un résonateur comportant un élément inductif multi-bande connecté entre une première électrode d'un condensateur dont la deuxième électrode est connectée à une ligne de transmission et la masse.

L'invention prévoit également une chaîne d'émission-réception radiofréquences multi-bande.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 décrite précédemment représente un exemple d'architecture classique de chaîne d'émission-réception radiofréquences bi-bande ;
la figure 2 décrite précédemment représente un exemple de schéma classique d'un élément d'adaptation d'impédance ;
la figure 3 représente le schéma électrique d'une inductance bi-bande selon un mode de réalisation de la présente invention ;
la figure 4 représente la caractéristique inductance-fréquence de l'élément de la figure 3 ;
la figure 5 représente, de façon très schématique et sous forme de blocs, une chaîne d'émission-réception radiofréquences bi-bande selon un mode de réalisation de la présente invention ;

la figure 6 représente la caractéristique d'adaptation d'impédance en fonction de la fréquence d'un élément d'adaptation d'impédance bi-bande du circuit de la figure 5 ;

la figure 7 représente le schéma d'un résonateur bi-bande selon un mode de réalisation de la présente invention ; et

la figure 8 illustre la caractéristique gain-fréquence du résonateur de la figure 7.

Les mêmes éléments ont été désignés par les mêmes références aux différentes figures. Pour des raisons de clarté, seuls les éléments nécessaires à la compréhension de l'invention ont été représentés aux figures et seront décrits par la suite. En particulier, les éléments des chaînes d'émission-réception radiofréquences autres que les éléments d'adaptation d'impédance propres à l'invention n'ont pas été détaillés et ne font pas l'objet de la présente invention.

Une caractéristique de la présente invention est de prévoir un circuit électronique passif formant un dipôle et réalisant la fonction d'une inductance bi-bande au moyen de deux éléments inductifs parallèles couplés et d'un condensateur. Plus généralement, l'invention prévoit la réalisation d'une impédance n bandes au moyen de n éléments inductifs couplés et de n-1 condensateurs.

La figure 3 représente le schéma électrique d'un élément inductif bi-bande 5 selon la présente invention. Un tel élément peut être connecté en série sur une ligne de transmission ou entre une ligne de transmission et un potentiel de référence. Dans l'exemple représenté, l'élément 4 a une borne 51 connectée à un potentiel de référence (généralement la masse). Dans l'exemple de la figure 3, la ligne de transmission peut être considérée comme des bornes d'entrée-sortie E, S de l'élément inductif 5. On notera que les bornes d'entrée-sortie ne sont alors pas directionnelles.

Comme l'illustre la figure 3, l'élément inductif bi-bande de l'invention comporte une première inductance L1 reliant les bornes 52 et 51 du dipôle formé, en parallèle avec une association en série d'une deuxième inductance L2 et d'un condensateur C2. L'inductance L2 et le condensateur C2 forment un circuit résonant série. De préférence, les inductances L1 et L2 sont couplées l'une à l'autre. Ce mode de réalisation a été illustré par un pointillé et la mention d'un coefficient de couplage k.

Un élément inductif 5 selon l'invention est dimensionné pour une fréquence de résonance choisie approximativement entre les deux fréquences de fonctionnement souhaitées pour l'inductance bi-bande. Par fréquence de fonctionnement, on entend la fréquence centrale de chacune des bandes passantes de l'élément inductif, ou les deux fréquences de coupure si cet élément est monté en résonateur comme cela sera illustré par la suite.

Pour une fréquence de fonctionnement très faible devant la fréquence de résonance de l'ensemble L2, C2, l'inductance équivalente Leq de l'élément 5 correspond approximativement à la valeur de l'inductance L1. Pour une fréquence de fonctionnement très nettement supérieure à la fréquence de résonance, l'inductance équivalente correspond approximativement à l'association en parallèle des deux inductances L1 et L2. Ceci, sans tenir compte du couplage k. En tenant compte du couplage k, l'inductance équivalente correspond à la mise en parallèle d'une inductance de valeur L1+kL2 avec une inductance de valeur L2+kL1.

De préférence, les deux inductances L1 et L2 ont la même valeur.

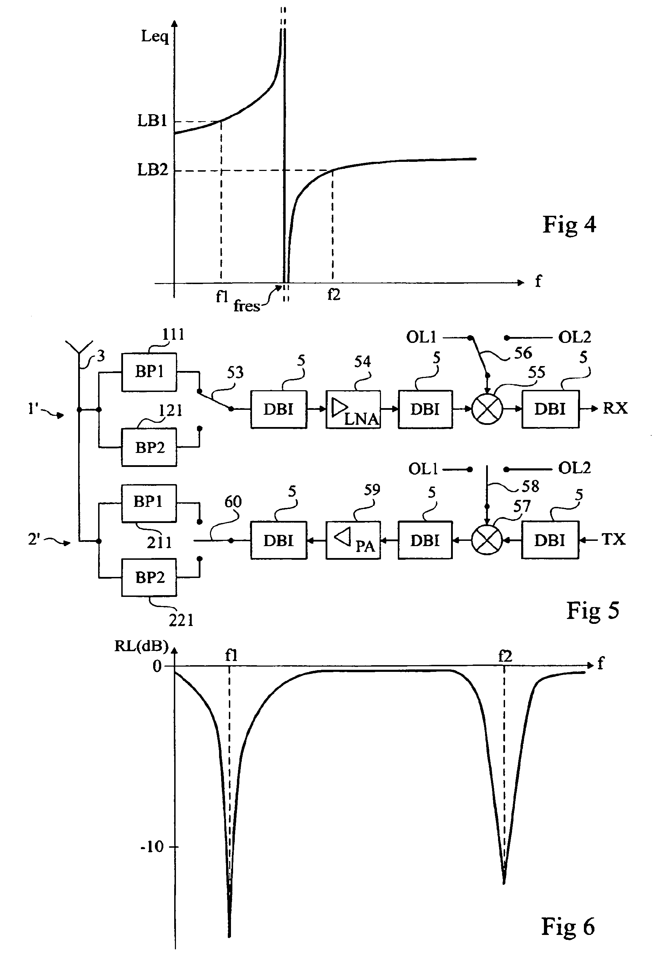

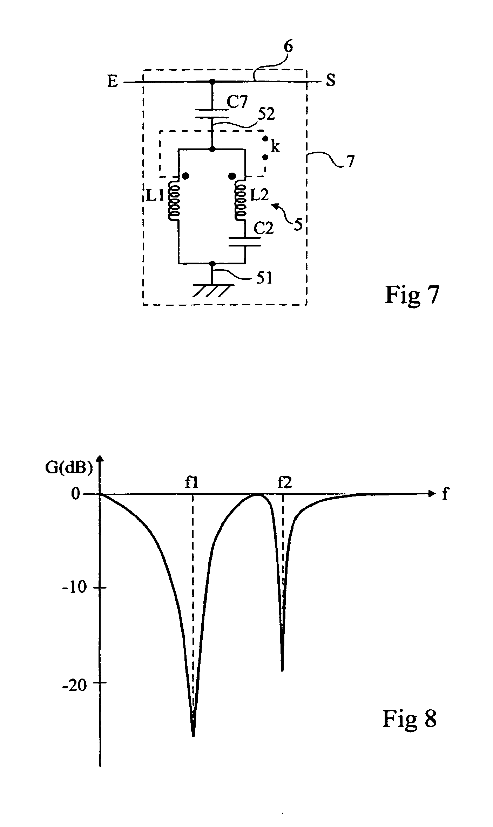

La figure 4 illustre la caractéristique inductance équivalente Leq de l'élément 5 de la figure 3 en fonction de la fréquence f. Pour une première fréquence f1 de l'élément inductif, celui-ci présente une valeur LB1 supérieure à une deuxième valeur LB2 qu'il atteint à une fréquence f2, les fréquences f1 et f2 étant autour de la fréquence de résonance fres de l'élément. Comme on le verra par la suite en relation avec les figures 6 et 8, les fréquences f1 et f2 correspondent respectivement à des fréquences d'adaptation d'impédance ou à des fréquences de réjection. Ce phénomène ne ressort pas de la figure 4 qui illustre uniquement l'évolution de la valeur de l'inductance équivalente.

Le dimensionnement d'un élément inductif 5 selon l'invention s'effectue, par exemple, de la façon suivante.

On commence par choisir la valeur de l'inductance L1 pour qu'elle corresponde approximativement à la valeur d'inductance souhaitée pour la première fréquence f1 de fonctionnement de l'élément inductif 5. Cette détermination revient à la détermination classique d'un élément inductif pour une application donnée. Par exemple, pour un circuit d'adaptation d'impédance classique (figure 2), on sait déterminer l'inductance L4 voulue pour la fréquence de fonctionnement de la voie concernée.

On détermine ensuite la valeur approximative de l'inductance L2 de telle sorte que l'inductance équivalente des deux éléments L1 et L2 en parallèle corresponde à l'inductance souhaitée pour la fréquence de fonctionnement f2. Là encore, la valeur souhaitée d'inductance pour la deuxième fréquence est fonction de l'application et déterminée de façon classique. La valeur de l'inductance L2 est donc choisie en appliquant la formule suivante :

$$\mathtt{L2\ =\ Leq.L1/(L1-Leq).}$$

On choisit ensuite la valeur du condensateur C2 en fonction de la fréquence de résonance. Comme cela a été indiqué précédemment, la fréquence de résonance est approximativement déterminée comme étant entre les deux fréquences f1 et f2 de fonctionnement souhaitées pour l'élément inductif bi-bande (fres = (f1+f2) /2) .

En fait, avec un couplage k entre les inductances L1 et L2, la fréquence de résonance fres est donnée approximativement par la relation suivante :

$$\text{fres} \approx \frac{1}{2 \cdot \pi \cdot \sqrt{(L2 - kL1 + L1 - kL2) \cdot C2}}.$$

Pour le couplage k, on prend, par exemple, une valeur comprise entre 0,5 et 0,8.

Après avoir évalué approximativement les valeurs à donner aux éléments L1, L2 et C2 de l'élément inductif, celui-ci est optimisé en fonction de l'application en utilisant des outils de simulation parfaitement connus et habituels dans la réalisation de circuits électroniques.

Pour utiliser l'élément de la figure 3 dans un circuit d'adaptation d'impédance d'un circuit (pointillé 50) connecté à la borne S, on prévoit généralement un condensateur (pointillé C8) en entrée (entre la borne 52 et la borne E) .

La figure 5 représente un mode de réalisation d'une chaîne d'émission-réception radiofréquences bi-bande selon la présente invention.

Comme précédemment, des voies de réception 1' et d'émission 2' sont connectées par une extrémité à une antenne 3, et leurs autres extrémités respectives sont reliées à un système d'exploitation de données reçues RX et de données à transmettre TX.

Selon l'invention, les éléments d'adaptation d'impédance 5 (DBI) sont constitués d'éléments bi-bande tels qu'illustrés en relation avec la figure 3. Grâce aux recours à des éléments bi-bande, il est désormais possible de partager, pour chaque voie (émission, réception), un même amplificateur et un même mélangeur. Ainsi, la voie de réception 1' comporte deux filtres passe-bande 111 (BP1) et 121 (BP2) en parallèle entre l'antenne 3 et un interrupteur 53 de sélection de bande passante. En aval, l'interrupteur 53 est connecté à un unique amplificateur faible bruit 54 (LNA) par l'intermédiaire d'un élément d'adaptation d'impédance bi-bande 5. La sortie de l'amplificateur 54 est connectée à un unique mélangeur 55 par l'intermédiaire d'un autre élément d'adaptation d'impédance bi-bande 5. De même, la sortie de l'élément mélangeur 55 est connectée à un élément 5. La deuxième entrée du mélangeur 55 est reliée à deux bornes de réception des fréquences d'oscillateurs OL1 et OL2 par un interrupteur 56 afin de sélectionner, en même temps que le filtre passe-bande de la bande concernée, la fréquence de l'oscillateur local du mélangeur.

Côté chaîne d'émission, on retrouve un unique mélangeur 57 encadré par deux éléments d'adaptation d'impédance 5 et dont l'entrée d'oscillateur local est connectée par un interrupteur 58 à deux bornes d'application des fréquences d'oscillateur local OL1 et OL2. Un unique amplificateur d'émission 59 (PA) reçoit le signal issu du mélangeur 57 après traversée d'un élément d'adaptation d'impédance 5, et est relié par un élément d'adaptation d'impédance 5, à un interrupteur 60 de sélection entre un filtre passe-bande 211 (BP1) et un filtre passe bande 221 (BP2) afin de sélectionner la bande passante de la chaîne d'émission.

En fonction de la constitution des filtres passe-bande, on pourra également prévoir des interrupteurs de sélection côté antenne 3 afin d'isoler complètement les filtres non utilisés.

La figure 6 représente la caractéristique d'adaptation d'impédance en fonction de la fréquence des éléments d'adaptation d'impédance 5 de l'architecture de chaîne d'émission-réception radiofréquences de la figure 5. Ces éléments sont dimensionnés pour disposer d'une première fréquence de coupure en réflexion f1 correspondant à la fréquence centrale de la première bande passante (BP1) et une deuxième fréquence de coupure f2 en réflexion correspondant à la fréquence centrale de la deuxième bande passante BP2. Dans l'exemple d'application à la téléphonie mobile pour les bandes GSM et DCS, les fréquences f1 et f2 sont respectivement de 900 MHz et 1800 MHz.

L'adaptation d'impédance se caractérise notamment, comme l'illustre la figure 6, par les pertes en réflexion RL (return loss) qui correspondent, en fonction de la fréquence, au rapport entre la puissance réfléchie sur un port et la puissance qui sort de ce même port.

Selon l'exemple d'application à la téléphonie mobile, un circuit à adapter connecté à la borne S (figure 3) et présentant, à 900 MHz, une impédance de 39 ohms - j151 ohms (j désignant la partie imaginaire d'un nombre complexe) et, à 1800 MHz, une impédance complexe de 16 ohms - j78 ohms, peut être adapté à 50 ohms pour les deux fréquences avec une inductance bi-bande conforme au mode de réalisation de la figure 3 avec les valeurs suivantes : inductances L1 et L2 de même valeur (7,4 nanohenrys) couplés avec un coefficient de 0,7 ; condensateur C2 de 2,21 picofarads et condensateur C8 de 850 femptofarads. L'impédance vue de la borne E est alors de 50 ohms pour les deux fréquences de 900 MHz et 1,8 GHz. Avec un tel circuit d'adaptation, on obtient des pertes en réflexions (figure 6) de respectivement -14 à 900 MHz et -13 dB à 1,8 GHz.

La figure 7 illustre une deuxième application de la présente invention à la réalisation d'un résonateur bi-bande. Le circuit résonateur 7 représenté en figure 7 comporte un élément inductif bi-bande du type de celui représenté en figure 3 dont la borne 52 opposée à la masse 51 est connectée, par un condensateur C7, à une ligne de transmission symbolisée par des entrée-sortie E et S de l'élément résonateur 7.

La figure 8 illustre la caractéristique gain-fréquence de réponse de l'élément résonateur de la figure 7. Celui-ci comporte deux fréquences de coupure f1 et f2 pour lesquelles l'atténuation est de l'ordre de -20 dB au minimum. Dans l'exemple d'application aux fréquences autres que celles de la téléphonie mobile GSM (900 MHz) et DCS (1,8 GHz), par exemple les standards WCDMA, WLAN ou Bluetooth, on peut utiliser un élément inductif bi-bande avec des composants tels que ceux décrits précédemment en relation avec la figure 3 et avec un condensateur C7 de valeur de 3,5 picofarads. On obtient alors un résonateur ayant des atténuations respectivement de -27 et -18 dB aux fréquences de 900 MHz et 1,8 GHz. On rejette ainsi les fréquences GSM et DCS.

Un résonateur tel qu'illustré par la figure 7 peut, par exemple, être utilisé en complément des filtres passe-bande d'une chaîne d'émission-réception radiofréquences (côté antenne 3) afin d'améliorer la réponse du filtre. Plus précisément, de tels résonateurs complémentaires permettent de réduire l'ordre des filtres nécessaires.

Un avantage de la présente invention est qu'elle permet la réalisation d'une impédance bi-bande d'encombrement réduit. En effet, la réalisation des deux inductances L1 et L2 en circuit intégré peut être effectuée en superposant les deux enroulements inductifs en raison du couplage k souhaité entre ces deux inductances. Par conséquent, on divise par au moins deux l'encombrement nécessaire par rapport à la réalisation de deux éléments d'adaptation d'impédance classique (figure 1). De plus, un avantage induit de l'invention est qu'elle permet de partager alors d'autres éléments du circuit, par exemple, les mélangeurs et amplificateurs des chaînes d'émission radiofréquences, ce qui réduit encore l'encombrement du circuit.

Selon un autre exemple d'application de l'invention, l'élément inductif bi-bande peut être transformé en filtre programmable en prévoyant une capacité C2 (figure 3), C7 (figure 7) ou encore la capacité d'entrée d'un circuit d'adaptation (C8, figure 3) variable (par exemple, une varicap ou analogue). Une telle modification est à la portée de l'homme du métier à partir des indications fonctionnelles données ci-dessus.

Bien entendu, la présente invention est susceptible de diverses variantes et modifications qui apparaîtront à l'homme de l'art. En particulier, les dimensions à donner aux éléments inductifs et capacitifs de l'élément inductif bi-bande de l'invention dépendent de l'application et pourront être déterminées avec des outils classiques d'optimisation à partir de valeurs approximatives déterminées comme indiqué dans la présente description.

De plus, bien que l'invention ait été décrite avec une application particulière à la téléphonie mobile bi-bande GSM et DCS, elle s'applique à d'autres bandes de fréquences sans difficulté.

En outre, l'invention n'est pas limitée à une inductance bi-bande mais peut être mise en oeuvre pour réaliser une inductance multi-bande prenant des valeurs différentes à différentes fréquences. On prévoit autant d'inductances (par exemple, n) en parallèle que de fréquences de travail ou bandes souhaitées (n) et un condensateur en série avec chacune des inductances sauf une (n-1 condensateurs). Toutes les inductances sont couplées deux à deux. Le dimensionnement à prévoir pour les différents éléments se déduit de l'exposé ci-dessus en relation avec une inductance bi-bande.

Enfin, dans l'application à un circuit d'adaptation d'impédance, l'inductance bi ou multi-bande de l'invention peut être utilisée dans d'autres schémas que celui de la figure 2 recourant à un condensateur série sur la ligne de transmission et où l'inductance de l'invention (figure 3) remplace l'inductance mono-bande usuelle. Par exemple, une inductance bi ou multi-bande selon l'invention peut être associée à d'autres inductances ou condensateurs dans une configuration série ou parallèle.

**Revendications**

1. Elément inductif multi-bande (5) en circuit intégré, qui définit un dipôle comprenant au moins deux branches parallèles comprenant, respectivement, une première inductance (L1) et une deuxième inductance (L2) en série avec un condensateur (C2), **caractérisé en ce que** les deux inductances sont couplées l'une à l'autre.

2. Elément inductif selon la revendication 1, dans lequel n branches parallèles comprennent chacune une inductance, n-1 de ces branches comprenant en outre un condensateur en série, afin de constituer un élément inductif à n bandes prenant des valeurs différentes à différentes fréquences.

3. Elément inductif selon la revendication 1 ou 2, dans lequel les inductances (L1, L2) sont réalisées par des enroulements conducteurs plan superposés.

4. Elément inductif selon l'une quelconque des revendications 1 à 3, dans lequel la valeur de la première inductance (L1) est choisie en fonction d'une première fréquence de coupure ou à la fréquence centrale d'une première bande d'adaptation d'impédance de l'élément inductif.

5. Elément inductif selon la revendication 4, dans lequel la valeur de la deuxième inductance (L2) est choisie pour correspondre approximativement à une valeur telle que l'inductance équivalente (Leq) des deux éléments en parallèle soit fonction d'une deuxième fréquence de coupure ou pour la fréquence centrale d'une deuxième bande d'adaptation d'impédance de l'élément inductif.

**6.** Elément inductif selon la revendication 4 ou 5, dans lequel la valeur du condensateur (C2) est choisie en fonction d'une fréquence de résonance souhaitée pour l'élément bi-bande.

**7.** Elément inductif selon la revendication 6, dans lequel le condensateur (C2) est variable de sorte à réaliser un filtre programmable.

**Claims**

**1.** A multi-band inductive circuit (5) in an integrated circuit, forming a dipole comprising at least two parallel branches respectively comprising a first inductance (L1) and a second inductance (L2) in series with a capacitor (C2), **characterized in that** the two inductances are coupled to each other.

**2.** The inductive element of claim 1, wherein n parallel branches each comprise an inductance, n-1 of these branches further comprising a series capacitor, to form an inductive element with n bands, taking different values at different frequencies.

**3.** The inductive element of claim 1 or 2, wherein the inductances (L1, L2) are formed by superposed planar conductive windings.

**4.** The inductive element of any of claims 1 to 3, wherein the value of the first inductance (L1) is selected as a function of a first cut-off frequency or to the central frequency of a first impedance matching band of the inductive element.

**5.** The inductive element of claim 4, wherein the value of the second inductance (L2) is selected to approximately correspond to a value such that the equivalent inductance (Leq) of the two elements in parallel is a function of a second cut-off frequency or to the central frequency of a second impedance matching band of the inductive element.

**6.** The inductive element of claim 4 or 5, wherein the value of the capacitor (C2) is selected according to a resonance frequency desired for the two-band element.

**7.** The inductive element of claim 6, wherein the capacitor (C2) is variable, to form a programmable filter.

**Patentansprüche**

**1.** Ein Multiband induktiver Schaltkreis (5) in einem integrierten Schaltkreis, der einen Dipol bildet, der wenigstens zwei parallele Zweige aufweist, die jeweils eine erste Induktivität (L1) und eine zweite Induktivität (L2), die in Reihe mit einem Kondensator (C2) geschaltet ist, aufweisen, **dadurch gekennzeichnet, dass** die zwei Induktivitäten miteinander verbunden sind.

**2.** Das induktive Element nach Anspruch 1, wobei n parallele Zweige jeweils eine Induktivität aufweisen, wobei n-1 von diesen Zweigen ferner einen Kondensator in Reihe geschaltet aufweisen, um ein induktives Element mit n Bändern zu bilden, die unterschiedliche Werte bei unterschiedlichen Frequenzen annehmen.

**3.** Das induktive Element nach Anspruch 1 oder 2, wobei die Induktivitäten (L1, L2) durch das Überlagern von ebenen leitenden Windungen gebildet werden.

**4.** Das induktive Element nach einem der Ansprüche 1 bis 3, wobei der Wert der ersten Induktivität (L1) als eine Funktion einer ersten Grenzfrequenz ausgewählt wird oder als eine Mittenfrequenz eines ersten Impedanz angepassten Bandes des induktiven Elements.

**5.** Das induktive Element nach Anspruch 4, wobei der Wert der zweiten Induktivität (L2) so ausgewählt ist, dass er näherungsweise einem Wert entspricht, und zwar so, dass die Äquivalenzimpedanz (Leq) der zwei parallelen Elemente eine Funktion einer zweiten Grenzfrequenz ist oder die Mittenfrequenz eines ersten Impedanz angepassten Bandes des induktiven Elements.

6. Das induktive Element nach einem der Ansprüche 4 oder 5, wobei der Wert des Kondensators (C2) gemäß einer Resonanzfrequenz ausgewählt wird, die für das zwei-Band Element gewünscht ist.

7. Das induktive Element nach Anspruch 6, wobei der Kondensator (C2) variabel ist, um einen programmierbaren Filter zu bilden.

Fig 1

Fig 2

Fig 3

EP 1 473 833 B1

Fig 4

Fig 5

Fig 6

Fig 7

Fig 8